## Europäisches Patentamt
## European Patent Office
## Office européen des brevets

(11) Numéro de publication: **0 012 327**
**B1**

(12) **FASCICULE DE BREVET EUROPEEN**

(45) Date de publication du fascicule du brevet: **05.05.82**

(51) Int. Cl.³: **C 23 F 1/02, C 23 C 15/00, B 23 P 1/00**

(21) Numéro de dépôt: **79104891.1**

(22) Date de dépôt: **04.12.79**

(54) Procédé lithographique de décapage par ions réactifs.

(30) Priorité: **18.12.78 US 970591**

(43) Date de publication de la demande:
**25.06.80 Bulletin 80/13**

(45) Mention de la délivrance du brevet:
**05.05.82 Bulletin 82/18**

(84) Etats contractants désignés:
**DE FR GB**

(56) Documents cités:
**FR - A - 2 312 114**
**GB - A - 806 381**
**US - A - 3 410 774**
**US - A - 3 860 783**
**US - A - 3 971 684**
**US - A - 3 984 301**
**US - A - 4 132 586**

**I.B.M. TECHNICAL DISCLOSURE BULLETIN,
vol. 8, n° 8, janvier 1966, pages 1030—1031
P. D. DAVIDSE: "Masking Technique for
cathodic sputter etching"**

(73) Titulaire: **International Business Machines
Corporation
Armonk, N.Y. 10504 (US)**

(72) Inventeur: **Bassous, Ernest
750 Kappock Street
Riverdale, New York 10463 (US)**
Inventeur: **Ephrath, Linda Mero
12 N Nabby Road
Danbury, Connecticut 06810 (US)**

(74) Mandataire: **Gallois, Gerard
COMPAGNIE IBM FRANCE Département de
Propriété Industrielle
F-06610 - La Gaude (FR)**

(56) References cited:
**JAPANESE JOURNAL OF APPLIED PHYSICS,
vol. 16, n° 2, 1977, pages 381—382
H. KINOSHITA et al.: "Anisotropic etching of
silicon by gas plasma"**

Courier Press, Leamington Spa, England.

Procédé lithographique de décapage par ions réactifs.

## Description

### Domaine technique

La présente invention concerne un procédé de décapage par ions réactifs qui fait appel à l'emploi d'un masque (physique) amovible qui n'est pas polarisé.

### Etat de la technique antérieure

Lors de la fabrication de microstructures, il est souvent nécessaire de définir de petites configurations géometriques sur des surfaces qui ne sont pas planes ou qui présentent des évidements, des dépressions, des tranchées, des perforations, etc. Les microstructures tridimensionelles telles que les buses d'éjection d'encre, les électrodes de charge, les guides d'ondes optiques, les transducteurs miniaturisés, et autres dispositifs analogues, ne se prêtent pas à la mise en oeuvre de techniques photolithographiques classiques.

Le décapage des configurations désirées constitue la partie la plus délicate et la plus cruciale de la fabrication de telles structures. Un procédé de décapage très employé consiste à plonger la surface à décaper recouverte d'un masque approprié de manière contiguë dans une solution chimique qui attaque cette surface tout en laissant le masque intact. En raison du décapage latéral chimique sous-jacent au masque, cette technique ne permet pas d'obtenir un décapage bien défini dans le cas de petites configurations géométriques.

Une technique appelée décapage par plasma a été proposée aux fins de la réalisation de blocs semi-conducteurs microélectroniques tels que des circuits intégrés en silicium. Cette technique consiste généralement à remplir une enceinte telle qu'une cloche d'un gaz tel que du $CF_4$ dont les ions constituants et les radicaux neutres sont chimiquement réactifs. En pratique, la surface à décaper est recouverte en contact étroit d'un masque et introduite dans la cloche de même que le gaz réactif. On provoque ensuite une dissociation de ce dernier, de manière à obtenir des ions positifs et des électrons, en appliquant une alimentation HF au plasma par couplage capacitif ou inductif. Il se produit alors, semble-t-il, une interaction chimique entre le gaz réactif et la surface à décaper. Dans ledit procédé, les substrats sont disposés sur un plan qui est à la masse ou qui est au même potentiel que les gaz constituant le plasma. De même que les techniques de décapage chimique, le décapage par plasma présente l'inconvénient de provoquer un décapage latéral sous-jacent au masque. Dans cette technique, les masques employés sont contigus aux surfaces du substrat et sont formés au moyen de techniques photolithographiques.

Une autre technique de décapage est connue sous l'appellation de décapage par pulvérisation. Cette dernière technique est mise en oeuvre dans une enciente telle qu'une cloche que l'on remplit d'un gaz inerte, par exemple de l'argon. Une anode et une cathode sont disposées dans cette cloche. La cathode est polarisée négativement par rapport à l'anode grâce à l'application d'un signal HF.

La surface à décaper est recouverte d'un masque approprié et l'ensemble masque-substrat est ensuite placé, sur la cathode. Ce masque n'est pas polarisé par rapport à la cathode. De même que dans les procédés précédemment décrits, le masque est formé sur les surfaces à décaper au moyen d'une technique photolithographique et est contigu à celles-ci. Lorsqu'une tension HF est appliquée à la cathode, le gaz inerte qui se trouve dans la région comprise entre la cathode et l'anode est ionisé et les ions positifs sont attirés vers la cathode. Les ions qui frappent la surface à décaper servent à arracher des atomes à celle-ci, ce qui se traduit par un décapage graduel à travers le matériau.

La technique de décapage par pulvérisation a récemment été améliorée grâce à l'addition d'un gaz chimiquement réactif tel que le $CF_4$ (cf. les brevets des E.U.A. Nos. 3 971 684 et 3 984 301). De même que dans toutes les autres techniques ci-dessus, la configuration de décapage est obtenue par l'intermédiaire d'un masque photolithographique qui est contigu à la surface décapée.

Le brevet des E.U.A. No. 3 410 774 décrit bien une technique de décapage par pulvérisation à l'aide d'un masque amovible non contigu à la surface décapée; cependant le dispositif de ce document n'est prévu que pour réaliser le nettoyage des contaminants de surface d'une pièce à traiter et non pour un procédé photolithographique. La distance entre le masque et la pièce à traiter est limitée à 0,050mm et ce dispositif ne peut pas décaper des configurations à définition élevée. De plus il ne peut être utilisé pour des surfaces de pièces tridimensionnelles ou pour réaliser des décapages sur des surfaces non planes.

### Exposé de l'invention

Un problème que posent les techniques de l'art antérieur réside dans le fait que des techniques de masquage photolithographiques sont utilisées pour engendrer des configurations. Ces techniques exigent que la lithographique proprement dite soit effectuée à la surface de l'élément qui fait l'objet du traitement (ci-après appelé "pièce"). Elles se prêtent malaisément à la fabrication de microstructures présentant de petites configurations géométriques bien définies sur des surfaces qui ne sont pas planes ou qui comportent des évidements, des tranchées, des dépressions, etc. De telles microstructures comprennent, par exemple, les buses d'éjection d'encre, les électrodes de charges, les guides d'onde optique, les transducteurs miniaturisés, les dispositifs micro-électroniques topographiquement structurés, etc. Les films de résistant photosensible qui sont utilisés dans le cadre de ces techniques ne recouvrent pas de façon adéquate les marches ou des avancées nettement définies ou les dépressions profondes que peut comporter la surface à décaper. Ces films tendent à devenir trop minces ou à présenter une solution de discontinuité au bord d'une avancée ou, dans le cas d'une dépression profonde, à s'accumuler dans cette dernière en quantité excessive. Le même type de problème se pose lors du dépôt de films minces sur la surface de telles microstructures par évaporation, pulvérisation, etc.

Selon l'invention, les problèmes afférents aux techniques lithographiques des procédés de l'art antérieur pourraient être résolus grâce à l'emploi d'un masque physique disposé à proximité immédiate du substrat à décaper, en raison du fait que la configuration du masque lui-même, bien qu'elle soit obtenue au moyen de techniques lithographiques standard, peut être réalisée sur des surfaces très plates et lisses. Il est donc inutile que la pièce faisant l'objet du traitement présente une topographie lisse et plate.

La présente invention concerne un procédé de décapage d'une pièce par ion réactifs. Ce procédé consiste notamment à disposer un masque physique à proximité immédiate de la pièce à décaper, à placer la pièce ainsi masquée sur une cathode, puis à disposer cette dernière ainsi que la pièce dans une enceinte dans laquelle un gaz de décapage est ensuite introduit. Ce dernier peut être un gaz quelconque utilisé dans l'art antérieur aux fins d'un décapage par ions réactifs, par exemple, un fluorocarbone ou un fluorocarbone chloré en présence d'additifs tels que de l'$O_2$, du He ou de l'$H_2$.

Un potentiel alternatif est appliqué à la cathode de manière à provoquer une dissociation du ou des gaz réactifs et à accélérer les ions chimiquement réactifs du gaz de décapage vers la cathode.

Le procédé de la présente invention, qui comporte l'emploi d'un masque physique en conjonction avec un décapage par ions réactifs permet d'obtenir des configurations présentant une résolution élevée sur des surfaces planes ou non et sur des structures tridimensionelles.

Le masque peut être réalisé à partir d'un unique matériau métallique ou non métallique ou de matériaux multiples tels que des structures possédant un revêtement, par exemple: Al, Si, acier, Cr, Ni, tout solide recouvert de $SiO_2$, Al, ou MgO, à condition que les surfaces ne soient pas susceptibles d'être décapées. Une tranche de silicium recouverte d'un métal, par exemple de l'Al, des matériaux recouverts d'Al et/ou de MgO sont également utilisables. Les matériaux employés ne doivent pas être érodés de façon appréciable ni être attaqués par le plasma.

Le masque est de préférence réalisé à partir d'une tranche de Si recouverte d'une couche protectrice de passivation, qui peut être constituée par un ou plusieurs des matériaux suivants: $SiO_2$, $Si_3N_4$, AIN et un verre. La couche de passivation est elle-même recouverte d'un matériau qui n'est pas susceptible d'être décapé, à savoir de l'Al ou du MgO.

Contrairement aux procédés de pulvérisation de l'art antérieur dans lesquels des masques sont employés, le masque utilisé dans la présente invention n'a pas à être placé en contact intime avec le substrat à décaper et il n'est pas indispensable qu'il soit polarisé par rapport au substrat. On notera que le masque décrit dans le brevet précité No. 3 410 774 ne peut pas être employé pour délimiter des surfaces tridimensionelles, contrairement à la présente invention. Toutefois, l'invention décrite dans ledit brevet constitue une technique de délimitation relativement grossière. Par exemple, l'ouverture pratiquée dans le masque doit être plus large de 0,025 à 0,050 mm que le trou à décaper, alors que dans la présente invention le trou à décaper est plus petit que la différence entre les dimensions de l'ouverture et le trou décapé de l'art antérieur. Le présent masque peut être disposé à une distance de 0,254 à 0,762 mm du substrat et continue alors à fournir une bonne définition de configuration.

Dans les techniques de l'art antérieur, il est nécessaire que le masque soit extrêmement mince. Pour obtenir des trous de 0,025 mm ou moins, ce qui est rendu possible par la présente invention, il est nécessaire que l'épaisseur du masque de l'art antérieur ne dépasse pas la moitié de la dimension de l'ouverture. Par exemple, dans le brevet précité No. 3 410 774, l'épaisseur du masque ne devrait pas dépasser 0,038 mm. Des masques d'une aussi faible épaisseur sont d'un emploi difficile en pratique. Dans la présente invention, l'épaisseur du masque est indépendante de la dimension de l'ouverture. En conséquence, on peut utiliser un masque d'une épaisseur de 0,762 mm ou davantage et obtenir des définitions très fines. Compte tenu de la nécessité de placer le masque en contact intime avec le substrat et d'employer un masque très mince (d'une épaisseur, par exemple, d'environ 0,050 mm), il est indispensable, dans les procédés de l'art antérieur, que les surfaces traitées soient très planes et très lisses. De ce fait, les surfaces présentant une topographie inhabituelle ou accidentée, par exemple les structures comportant des trous, des cavités, etc., ne peuvent pas être décapées avec une définition fine, alors que dans la présente invention une telle définition peut être obtenue.

La présente invention constitue un procédé lithographique qui est à la fois simple et peu coûteux. Ce procédé peut être mis en oeuvre en conjonction avec d'autres opérations effectuées sous vide sans avoir à effectuer plusieurs

transfers d'un système à un autre. Par exemple, le dépôt d'un métal et/ou une opération de pulvérisation peuvent être effectués dans un même système. Une chambre à vide pourvue d'un équipement de décapage et de dépôt peut aisément être réalisée. Les opérations de dépôt, de décapage, etc., peuvent être effectuées de façon séquentielle.

L'emploi de la technique de décapage par ions réactifs est bien connu. On ignorait toutefois jusqu'à la présente invention que cette technique pouvait être utilisée efficacement à des fins lithographiques, notamment aux fins de la réalisation de microstructures tridimensionelles. On a constaté dans le cadre de la présente invention que la technique de décapage par ions réactifs, utilisée en conjonction avec un masque physique dans lequel une configuration présentant une résolution élevée a été décapée, permettait de reproduire cette configuration sur une surface.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

La Figure 1 est une coupe schématique d'un appareil susceptible d'être utilisé pour mettre en oeuvre le procédé de la présente invention.

La Figure 2 est une coupe d'un porteéchantillon utilisant le masque de la présente invention.

Description de l'invention

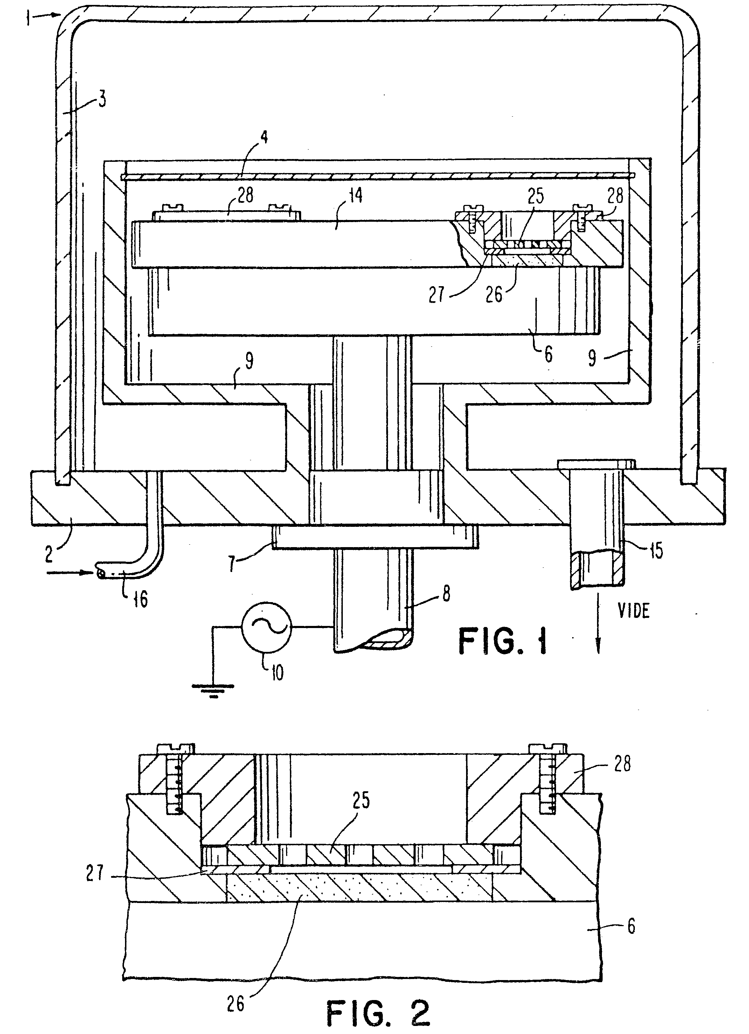

On a schématiquement représenté sur la Figure 1 un appareil permettant de mettre en oeuvre le procédé de la présente invention. Cette figure représente une enciente sous vide 1 comprenant une plaque 2 servant de base et une cloche 3 qui peut être en verre ou en métal, et qui est hermétiquement fixée à la plaque 2. Le volume d'une enciente particulière utilisée dans le cadre de la présente invention était d'environ 15 litres. L'enciente 1 contient une plaque d'anode 4 et une plaque de cathode 14. La plaque 14 est connectée électriquement et mécaniquement à la cathode 6. La plaque d'anode 4 est disposée en face de la plaque de cathode 14. Dans certains agencements, l'enceinte tout entière fait fonction d'anode.

La cathode 6 est de préférence constituée par une électrode HF plane pourvue d'un support 8, une entretoise isolante 7 étant disposée entre le support 8 et la base 2 de manière à maintenir la cathode 6 dans une position pratiquement parallèle à la base 2. L'électrode 6 est entourée d'un écran 9. D'autre part, la cathode 6, qui en principe en cuivre, peut être pourvue d'une conduite (non représentée) permettant éventuellement de refroidir au moyen d'un fluide approprié la plaque 14. Une alimentation alternative et de préférence une alimentation HF 10 est connectée entre le support 8 de l'électrode et la masse.

La plaque d'anode 4 est connectée électriquement et mécaniquement à l'écran 9 et est à la masse. La plaque 4 est de préférence disposée à une distance d'environ 2,54 cm de la cathode et est perforée. Bien que des densités de puissance relativement basses soient en principe utilisées, la matériau de la plaque de cathode 14 a tendance à faire l'objet d'une pulvérisation lorsqu'elle est constituée par un métal tel que de l'aluminium, de l'acier inoxydable ou du cuivre. Lorsque cela se produit, l'anode recueille le métal ainsi pulvérisé et s'oppose à sa diffusion sur la surface que l'on décape.

L'enceinte 1 comprend une conduite d'évacuation 15 qui permet de faire le vide dans cette enceinte et qui est connectée à une pompe (non représentée). L'enceinte peut ainsi être évacuée avant que les pièces puissent être exposées au procédé de la présente invention. L'enceinte comprend également une conduite 16, qui est pourvue d'une valve à débit variable (non représentée) et d'un débitmètre (non représenté). Ces deux derniers dispositifs pourraient évidemment être remplacés par d'autres dispositifs assurant les mêmes fonctions tel qu'un contrôleur de débit. La conduite 16 est reliée à des réservoirs dans lesquels les gaz sont emmagasinés.

Le masque 25 peut être réalisé à partir d'un unique élément pourvu ou non d'un revêtement: acier inoxydable, Cu, Ni, Al, Si, Ge, GaAs, $Al_2O_3$ et matière plastique recouverte de glaçure. N'importe quel matériau solide peut être employé à la condition qu'il puisse être défini selon une configuration prédéterminée et qu'il soit capable de résister à l'environnement du décapage par ions réactifs.

Le masque peut être défini au moyen de techniques bien connues: usinage, électroformage, techniques lithographiques telles que photolithographie, lithographie faisant appel à l'emploi de rayons X ou de faisceaux électroniques, en combinaison avec les techniques de décapage nécessaires.

Le masque 25 est disposé à proximité immédiate de la pièce 26 dont il est séparé par des entretoises 27 qui peuvent être des rondelles et être réalisées au moyen d'un matériau approprié quelconque qui n'est pas susceptible d'être érodé par le processus de décapage. Ainsi qu'on l'a précédement indiqué, le masque 25 peut se trouver à une distance d'environ 0,762 mm audessus de la pièce 26, la distance préférée étant comprise entre 0,254 mm environ et 0,762 mm environ.

Dans la réalisation préférée, le masque est fabriqué conformément à une configuration désirée sur une unique tranche de silicium cristallin au moyen de techniques photolithographiques. La tranche est décapée de façon anisotrope, puis recouverte d'aluminium ou de MgO qui est capable de résister au décapage par ions réactifs.

Des ouvertures de 0,002 à 2,54 mm sont ensuite percées dans le masque. Les dimensions préférées de ces ouvertures sont comprises entre 0,002 mm environ et 0,254 mm environ.

Le masque 25, l'entretoise 27 et la pièce 26 sont placés dans un dispositif de maintien 28 que l'on introduit ensuite dans l'appareil de décapage par ions réactifs. L'opération de décapage est effectuée à température ambiante. La durée du décapage est fonction de la pression des gaz, du type de gaz, du débit des gaz et de la tension HF appliquée au plasma. Une fois le décapage terminé, le dispositif 28 contenant le masque 25 et la pièce 26 est retiré de l'appareil. Le masque peut être réutilisé si l'on a de nouveau besoin de la configuration qu'il comporte. Le présente procédé, qui comporte l'emploi dudit masque, supprime la nécessité de nettoyer et de retirer la résine photosensible ou autre matériau analogue.

La pièce soumise au procédé de la présente invention comprend un substrat recouvert d'une surface constituée de silicium, de l'oxyde de silicium tel que du SiO et du $SiO_2$ et/ou du nitrure de silicium et/ou les oxynitrures de silicium. Ladite surface peut être constituée par un matériau quelconque qui pourra être traité au moyen d'un gaz de décapage connu. Le substrat peut être constitué par l'un des substrats connus qui sont utilisés dans le cadre d'un décapage par ions réactifs, y compris les matériaux qui ne forment pas de fluorures volatils dans les conditions dans lesquelles le décapage est effectué.

Le procédé de la présente invention est généralement mis en oeuvre à des pressions comprises entre 5 et 200 millitorr environ (0,666 Pa et 26,664 Pa environ), et de préférence comprises entre 10 et 100 millitorr environ (1,333 Pa et 13,332 Pa environ).

La densité de puissance de l'alimentation HF est comprise entre 0,05 watt et 1 watt, et de préférence entre 0,1 et 0,5 watt par $cm^2$ de la cathode.

Le débit total des gaz est généralement d'au moins 10 $cm^3$ par minute. Le débit maximum est essentiellement fonction de la capacité du système de pompage. Le débit minimum préféré est d'enviro 20 $cm^3$ par minute, et le débit maximum préféré est d'environ 1000 $cm^3$ par minute.

La vitesse de décapage du silicium, des oxydes de silicium et des nitrures dans du $CF_4$ varie entre 500 to 1000 Å par minute dans les conditions de décapage préférées.

La plaque de cathode est de préférence constituée par un métal tel que l'aluminium. Ce métal fait fonction de puits de chaleur et, de ce fait le décapage peut être effectué à une vitesse élevée. Par ailleurs, ainsi qu'on l'a déjà mentionné, la cathode peut être refroidie par des moyens externes.

On a décrit ci-dessus un procédé lithographique de décapage par ions réactifs dans lequel un masque physique est employé pour définir des configurations sur une pièce sans qu'il y ait lieu d'utiliser un matériau résistant photosensible disposé contigu à ladite pièce. Celle-ci peut ou non être plane ou présenter une structure tridimensionelle. Le présent procédé permet de définir des dispositifs qui ne pouvaient pas l'être au moyen des techniques de masquage de l'art antérieur. Par exemple, le présent procédé permet de décaper un trou de plus faibles dimensions dans une plus grande cavité avec une résolution élevée. On peut commander les profils de l'ouverture décapée, par exemple passer d'un profil vertical à un profil incliné, en ajustant la hauteur du masque physique par rapport à la pièce. La pièce peut être soumise à plusieurs des étapes du traitement à l'intérieur de la chambre sans être retirée de cette dernière, par exemple.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé lithographique de décapage par ions réactifs pour définir des configurations présentant une résolution élevée sur les surfaces planes et non planes d'une pièce, en plaçant ladite pièce sur la cathode d'un système de décapage par ions réactifs et en l'exposant à un mélange gazeux d'ions réactifs, caractérisé en ce qu'un masque amovible et non polarisé par rapport à la cathode est disposé, pendant son exposition audit mélange gazeux, sans être en contact avec les surfaces à traiter, jusqu'à une distance maximum d'environ 0,762mm au-dessus de ces surfaces de ladite pièce, selon la définition requise des bords des lignes.

2. Procédé selon la revendication 1 caractérisé en ce que ce masque est disposé à une distance comprise entre 0,254mm environ et 0,762mm environ au-dessus des surfaces à traiter de ladite pièce.

3. Procédé selon l'une des revendications 1 ou 2, caractérisé en ce que ledit masque est constitué ou revêtu d'un matériau résistant de manière appréciable au plasma de décapage par ions réactifs.

4. Procédé selon l'une des revendications 1 à 3, caractérisé en ce que ledit masque est réalisé à partir d'un matériau choisi dans le groupe composé des matériaux suivants: Al, Si, acier, Cr, Ni, $SiO_2$ et MgO.

5. Procédé selon l'une des revendications 1 à 3, caractérisé en ce que ledit masque est réalisé à partir de silicium recouvert d'aluminium.

6. Procédé selon l'une des revendications 1 à 3, caractérisé en ce que ledit masque est réalisé à partir de silicium recouvert de MgO.

7. Procédé selon l'une des revendications 1 à 3, caractérisé en ce que ledit masque est réalisé à partir d'une tranche de silicium recouverte d'une couche protectrice d'un matériau de passivation choisi dans le groupe comprenant les matériaux suivants: $SiO_2$, $Si_3N_4$, $Al_2O_3$, AlN et un verre, et en ce que ladite couche de passivation est recouverte d'un matériau qui n'est pas susceptible d'être décapé et qui est constitué par de l'Al ou du MgO.

8. Procédé selon l'une des revendications 1 à 7, caractérisé en ce que la dimension des ouvertures dans le masque est comprise entre 0,002mm environ et 2,54mm environ.

9. Procédé selon la revendication 8 caractérisé en ce que la dimension des ouvertures dans le masque est comprise entre 0,002mm et 0,254mm environ.

## Patentansprüche

1. Lithographisches Verfahren zum reaktiven Ionenätzen zur Definition von Mustern mit hoher Auflösung auf ebenen und unebenen Oberflächen eines Werkstückes, bei dem das Werkstück auf die Kathode eines reaktiven Ionenätzsystems gelegt und einer Gasmischung aus reaktiven Ionen ausgesetzt wird, dadurch gekennzeichnet, daß eine abnehmbare und in bezug auf die Kathode nicht vorgespannte Maske, die während sie der Gasmischung ausgesetzt wird, nicht in Kontakt mit den zu behandelnden Oberflächen ist, in einer Entfernung bis zu etwa 0,762 mm über den Oberflächen des Werkstückes, entsprechend der geforderten Definition der Linienränder, angeordnet ist.

2. Verfahren nach Anspruch 1, dadurch gekennzeichnet, daß die Maske in einer Entfernung von ungefähr 0,254 mm bis 0,762 mm über den zu behandelnden Oberflächen des Werkstücks angeordnet ist.

3. Verfahren nach einem der Ansprüche 1 oder 2, dadurch gekennzeichnet, daß die Maske aus einem Material besteht oder damit beschichtet ist, das auf nennenswerte Weise gegenüber dem reaktiven Ionenätzplasma beständig ist.

4. Verfahren nach einem der Ansprüche 1 bis 3, dadurch gekennzeichnet, daß die Maske aus einem Material aus der Gruppe folgender Materialien: Al, Si, Stahl, Cr, Ni, $SiO_2$ und MgO erzeugt wird.

5. Verfahren nach einem der Ansprüche 1 bis 3, dadurch gekennzeichnet, daß die Maske aus Aluminium-beschichtetem Silicium besteht.

6. Verfahren nach einem der Ansprüche 1 bis 3, dadurch gekennzeichnet, daß die Maske aus MgO-beschichtetem Silicium besteht.

7. Verfahren nach einem der Ansprüche 1 bis 3, dadurch gekennzeichnet, daß die Maske aus einer mit einem Passivierungsmaterial bedeckten Silicumscheibe besteht, wobei dieses aus der Gruppe folgender Materialien gewählt wird: $SiO_2$, $Si_3N_4$, $Al_2O_3$, AlN und ein Glas, und daß die Passivierungsschicht mit einem ätzbeständigen Material beschichtet ist, das aus Al oder MgO besteht.

8. Verfahren nach einem der Ansprüche 1 bis 7, dadurch gekennzeichnet, daß die Größe der Maskenöffnungen zwischen ungefähr 0,002 mm und 2,54 mm liegt.

9. Verfahren nach Anspruch 8, dadurch gekennzeichnet, daß die Größe der Maskenöffnungen zwischen ungefähr 0,002 und 0,254 mm liegt.

## Claims

1. A lithographic reactive ion etching method for defining patterns having a high resolution on plane and non plane surfaces of a workpiece, where said workpiece is placed on the cathode of a reactive ion etching system and exposed to a reactive ion gas mixture, characterized in that a removable mask, non biased with respect to the cathode, is located during its exposure to said gas mixture, without being in contact with the surfaces to be processed, at a distance of up to approximately 0.762 mm above the surfaces of said workpiece according to the required line edge definition.

2. A method according to claim 1, characterized in that this mask is placed at a distance between approximately 0.254 mm and 0.762 mm above the surfaces to be processed of said workpiece.

3. A method according to any one of claims 1 or 2, characterized in that said mask consists of, or is coated with, a material which has a good resistance to the reactive ion etching plasma.

4. A method according to any one of claims 1 to 3, characterized in that said mask is produced from a material selected from the following group of materials: Al, Si, steel, Cr, Ni, $SiO_2$ and MgO.

5. A method according to any one of claims 1 to 3, characterized in that said mask is produced from aluminium/coated silicon.

6. A method according to any one of claims 1 to 3, characterized in that said mask is produced from MgO/coated silicon.

7. A method according to any one of claims 1 to 3, characterized in that said mask is produced from a silicon wafer coated with a protective layer of a passivation material selected from the group including the following materials: $SiO_2$, $Si_3N_4$, $Al_2O_3$, AlN and a glass, and that said passivation layer is coated with a material which is etch-resistant and consists of Al or MgO.

8. A method according to any one of claims 1 to 7, characterized in that the size of the apertures in the mask is between 0.002 mm and 2.54 mm.

9. A method according to claim 8, characterized in that the size of the apertures in the mask is between 0.002 mm and 0.254 mm.

FIG. 1

FIG. 2

1